# EUROPEAN PATENT APPLICATION

(11) **EP 1 970 913 A1**
(43) Date of publication of application: **17.09.2008**
(21) Application number: 08100020.0
(22) Date of filing: 02.01.2008
(51) Int. Cl.: G11C 16/22, G06F 12/14

(54) **Portable memory apparatus having a content protection function and method of manufacturing the same**

(30) Priority: 16.03.2007 KR 20070026269
(71) Applicant: Samsung Electronics Co., Ltd., Suwon-si, Gyeonggi-do 442-742 (KR)
(72) Inventor: Kim, Myung-sun, Gyeonggi-do (KR); Ju, Hak-soo, Gyeonggi-do (KR); Moon, Ji-young, Gyeonggi-do (KR)
(74) Representative: Clark, David James

(57) **Abstract**

A portable memory apparatus having a content protection function is provided. The portable memory apparatus includes a memory (310) and a memory control unit (320). The memory includes a read-only memory area (312) which stores content and is set to so that only read operations are allowed, a writable memory area (314) which is set so that read and write operations are allowed, and a special memory area (316) which stores information needed to operate the portable memory apparatus and is set so that only authenticated programs are allowed to read from and/or write to the special memory area (316). The memory control unit (320) controls the read and write operations on each of the areas.

## Description

### BACKGROUND OF THE INVENTION

### 1. Field of the Invention

Methods and apparatuses consistent with the present invention relate to a portable memory apparatus and a method of manufacturing the same.

### 2. Description of the Related Art

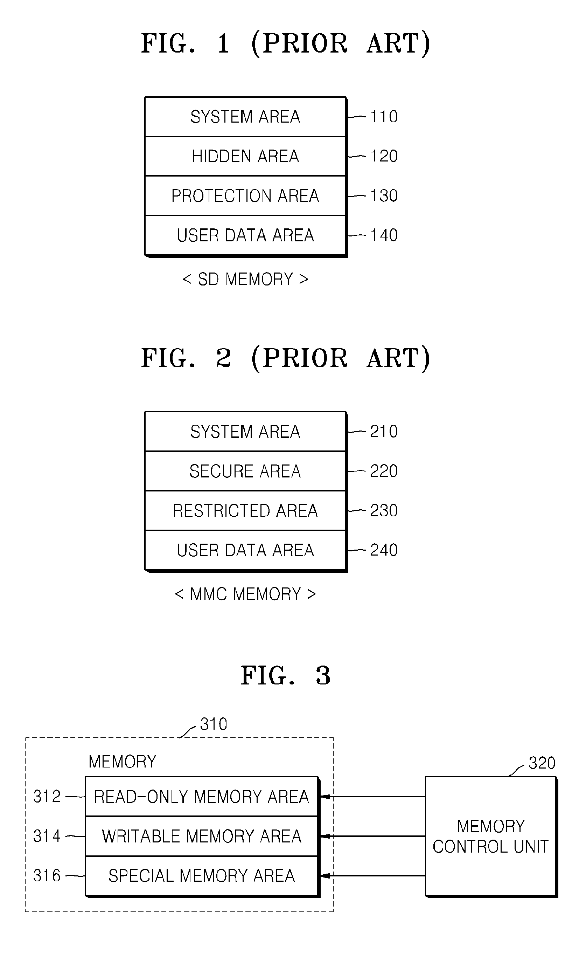

FIG. 1 illustrates a memory structure of a conventional secure digital (SD) memory card.

Referring to FIG. 1, the memory of the conventional SD memory card is divided into a system area 110, a hidden area 120, a protection area 130, and a user data area 140. The system area 110 stores a media ID and a media block which is a content key encrypted with a device key, and the system area 110 is set so that only read operations are allowed.

The hidden area 120 stores a media unique key, which is a private key for decrypting a content key encrypted with the device key, and a pre-defined random number. Also, the hidden area 120 is set so that only read operations are allowed.

The protection area 130 stores a usage restriction regulation so that the use of content is restricted, and only authenticated programs are allowed to read from and write to the protection area 130.

The user data area 140 stores data as desired by a user and is set so that read and write operations are allowed.

FIG. 2 illustrates a memory structure of a conventional multimedia card (MMC) memory card.

Referring to FIG. 2, the memory of the conventional MMC memory card is divided into a system area 210, a secure area 220, a restricted area 230, and a user data area 240.

The system area 210 stores a media ID and content key encrypted with a device key, which is a public key, and the system area 210 is set so that only read operations are allowed.
The secure area 220 stores a private key for decrypting the content key encrypted with the device key and is set so that only read operations are allowed.
The restricted area 230 includes a usage restriction regulation that restricts the use of the content, a certificate revocation list, and so on, and is set so that only authenticated programs are allowed to read from and write to the restricted area 230.
The user data area 240 stores data as desired by a user and is set so that read and write operations are allowed.
Conventional portable memory apparatuses do not have a memory area that can store content, except for a user data area. However, the content stored in the user data area is highly susceptible to being altered by others because the user data area allows read and write operations.

### SUMMARY OF THE INVENTION

Exemplary embodiments of the present invention aim to address the above disadvantages and other disadvantages not described above. According to an aspect of the present invention, there is provided a portable memory apparatus having a content protection function, including a memory and a memory control unit which controls read and write operations on each of areas of the memory. The memory includes a read-only memory area which stores content and is set to allow only read operations, a writable memory area which stores additional information related to the content or information as desired by a user and is set to allow read and write operations, and a special memory area which stores information needed to operate the portable memory apparatus and is set to allow only authenticated programs to be read therefrom and written thereto.

The special memory area may further include a program revocation list that shows whether a predetermined program is revoked, and the memory control unit may identify the predetermined program as an authenticated program unless the predetermined program is included in the program revocation list.

The read-only memory area may be set not to allow copy operations.

The content to be stored in the read-only memory may be encrypted with a predetermined content key, and a content key for decrypting the encrypted content may be stored in the special memory area.

When the content is encrypted by symmetric encryption, the special memory area may store a content key which is identical to the content key that is used in the symmetric encryption.

When the content is encrypted by asymmetric encryption, the special memory area may store, as a content key for decrypting, a private key that corresponds to a public key which is a content key used in the asymmetric encryption.

The special memory area may further store a content use restriction regulation to restrict the use of the content, and the memory control unit may control the use of the content based on the content use restriction regulation of the special memory area.

The content may include at least one of an audio, a video, a text, and software.

According to another aspect of the present invention, there is provided a method of manufacturing a portable memory apparatus having a content protection function, the method including the operations of: dividing a memory of the portable memory apparatus into a read-only memory area which is set to allow only read operations, a writable memory area which is set to allow read and write operations, a special memory area which is set to allow only authenticated programs to be read therefrom and/or written thereto; and storing content in the read-only memory area and storing information required to operate the portable memory apparatus, in the special memory area.

In the storing operation, a program revocation list to show whether a predetermined program is revoked may further be stored in the special memory area, and the predetermined program may be determined as an authenticated program unless the predetermined program is included in the program revocation list.

The read-only memory area may be set not to allow copy operations. The method of manufacturing a portable memory apparatus having a content protection function may further include the operation of encrypting content with a predetermined content key. In the storing operation, the encrypted content may be stored in the read-only memory area, and a content key for decrypting the encrypted content may be stored in the special memory area.

In the encrypting operation, the content may be encrypted by symmetric encryption, and in the storing operation, a content key, which is identical to the content key used in the symmetric encryption, may be stored in the special memory area.

In the encrypting operation, the content may be encrypted by asymmetric encryption, and in the storing operation, a private key that corresponds to a public key which is a content key used in the asymmetric encryption may be stored as a content key for decrypting in the special memory area.

The content may include at least one of an audio, a video, a text, and software.

According to the present invention there is provided an apparatus and method as set forth in the appended claims. Other features of the invention will be apparent from the dependent claims, and the description which follows.

### BRIEF DESCRIPTION OF THE DRAWINGS

For a better understanding of the invention, and to show how embodiments of the same may be carried into effect, reference will now be made, by way of example, to the accompanying diagrammatic drawings in which:
FIG. 1 illustrates a memory structure of a conventional secure digital (SD) memory card;
FIG. 2 illustrates a memory structure of a conventional multimedia card (MMC) memory card;
FIG. 3 is a block diagram of a portable memory apparatus having a content protection function, according to an exemplary embodiment of the present invention; and
FIG. 4 is a flowchart of a method of manufacturing a portable memory apparatus having a content protection function, according to an exemplary embodiment of the present invention.

### DETAILED DESCRIPTION OF EXEMPLARY EMBODIMENTS

The present invention will now be described more fully with reference to the accompanying drawings, in which exemplary embodiments of the invention are shown.

FIG. 3 is a block diagram of a portable memory apparatus having a content protection function, according to an exemplary embodiment of the present invention.

Referring to FIG. 3, the portable memory apparatus includes a memory 310 and a memory control unit 320.

The memory 310 includes a read-only memory area 312, a writable memory area 314, and a special memory area 316.

The read-only memory area 312 stores content and is set so that only read operations are allowed.

Since the read-only memory area 312 is set so that only reading operations are allowed, the content stored in the read-only memory area 312 is prevented from being altered by others.

The content may include audio, video, text, software, and/or other data.

The content to be stored in the read-only memory area 312 may be encrypted with a predetermined content key.

The reason for encrypting content is to prevent the content from being used by others that do not have a content key for decrypting the content. For example, one may want to encrypt content when the content stored in the read-only memory area 312 is to be copied and spread out to others through the internet.

The content key for decrypting the content may be stored in the special memory area 316, according to an exemplary embodiment of the present invention, or in a device such as a personal computer (PC) which may use the content.

The content to be stored in the read-only memory area 312 may be encrypted by a symmetric encryption or an asymmetric encryption. The read-only memory area 312 is set so that copy operations are not allowed. By doing so, the content stored in the read-only memory area 312 is prevented from being copied and spread out to others through means such as the internet.

The writable memory area 314 stores additional information related to the content, or other information as desired by a user, and is set so that read and write operations are allowed.

If the content is software, the additional information related to the content may be update information associated with the software, and if the content is a movie, the additional information related to the content may be a director's cut associated with the movie that is released after the movie.

There are no limits to the types of information that a user is able to store. However, for example, if the content is a movie, the user may want to store information associated with the movie characters or video clips of interviews with the movie characters.

The special memory area 316 stores information needed to operate the portable memory apparatus, and only authenticated programs are allowed to read from and/or write to the special memory area 316.

When an external device, such as a PC, is connected to the portable memory apparatus, the information needed to operate the portable memory apparatus may be obtained from the special memory area 316. Such information may include a memory address which is required to receive/transmit data between the external device and the portable memory apparatus.

The special memory area 316 may also include a program revocation list that shows whether a predetermined program is revoked.

The program revocation list serves as information required to determine whether a program trying to access to the special memory area 316 is authenticated.

For example, the program revocation list may include a list of revoked programs, and if a program is included in the program revocation list, then the program cannot read from and/or write to the special memory area 316.

The special memory area 316 may include a content key for decrypting encrypted content.

When content is encrypted by symmetric encryption, the special memory area 316 stores a content key which is identical to a content key used in the symmetric encryption. However, when content is encrypted by asymmetric encryption, the special memory area 316 stores, as a content key for decrypting, a private key that corresponds to a public key, wherein the public key is a content key used in the asymmetric encryption.

The special memory area 316 may include a content use restriction regulation so that the use of content is restricted.

That is, the special memory area 316 may include a content use restriction regulation where the content stored in the read-only memory area 312 should be used only 100 times, and the memory control unit 320, to be described later, may control the content so that it is used only 100 times.

The memory control unit 320 controls the read and write operations on each of the areas of the memory 310.

That is, when an external device such as a PC is connected to the portable memory apparatus, the memory control unit 320 controls data transmission between the external device and each of the areas of the memory 310 of the portable memory apparatus.

The memory control unit 320 also determines whether a predetermined program which tries to access the special memory area 316 is included in the program revocation list, that is, the memory control unit determines if the program is authenticated. Accordingly, only a program determined by the memory control unit 320 as an authenticated program is allowed to access the special memory area 316.

As described above, the memory control unit 320 may control the use of the content based on the content use restriction regulation.

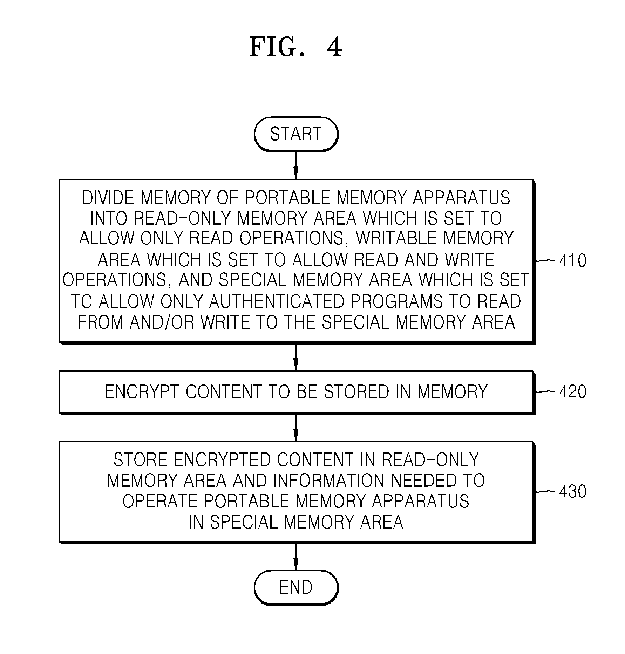

FIG. 4 is a flowchart of a method of manufacturing a portable memory apparatus having a content protection function, according to an exemplary embodiment of the present invention.

In operation 410, the memory of the portable memory apparatus is divided into a read-only memory area which is set so that only reading operations are allowed, a writable memory area which is set so that read and write operations are allowed, and a special memory area which is set so that only authenticated programs are allowed to read from and/or write to the special memory area.

In operation 420, content to be stored in the memory is encrypted.

However, the content may not be encrypted in some embodiments. In operation 430, the encrypted content is stored in the read-only memory area, and information needed to operate the portable memory apparatus is stored in the special memory area.

When the content is not encrypted, the content is stored in the read-only memory area.

A content provider may store to-be-sold content in the portable memory apparatus having a content protection function illustrated in FIG. 3, in order to prevent the risk of the content being altered by others.

In contrast with conventional CD-ROMs or DVDs that store content, the portable memory apparatus of FIG. 3 can store information as desired by a user, so that a user who purchases the portable memory apparatus including the content can store and use information related to the content in the writable memory area 314 of the portable memory apparatus.

A portable memory apparatus having a content protection function according to an exemplary embodiment of the present invention includes a memory and a memory control unit. The memory includes a read-only memory area which stores content and is set so that only read operations are allowed, a writable memory area which stores additional information related to the content or other information as desired by a user and is set so that read and write operations are allowed, and a special memory area which stores information needed to operate the portable memory apparatus and is set so that only authenticated programs are allowed to read from and/or write to the special memory area. The memory control unit controls the read and write operations on each of the areas. Accordingly, content included in the memory can be prevented from being altered. Moreover, other information that the user may want to store can be stored in the portable memory apparatus in addition to the already included content.

The exemplary embodiments of the present invention can be written as computer programs and can be implemented in general-use digital computers that execute the programs using a computer readable recording medium. Examples of the computer readable recording medium include magnetic storage media (e.g., ROM, floppy disks, hard disks, etc.), optical recording media (e.g., CD-ROMs, or DVDs), and storage media such as carrier waves (e.g., transmission through the Internet).

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A portable memory apparatus comprising:
a memory (310) including a plurality of areas; and
a memory control unit (310) which controls read and write operations on each of the areas of the memory,
wherein the plurality of areas comprise:
a read-only memory area (312) which stores content and is set so that only read operations are allowed;
a writable memory area (314) which is set so that read and write operations are allowed; and
a special memory area (316) which stores information needed to operate the portable memory apparatus, wherein the special memory area is set so that only authenticated programs are allowed to at least one of read from and write to the special memory area.

2. The portable memory apparatus of claim 2, wherein the writable memory area (314) stores at least one of additional information related to the content and other information.

3. The portable memory apparatus of claim 1 or 2, wherein the special memory area (316) further comprises a program revocation list which lists a predetermined program that is revoked, and
wherein the memory control unit (320) identifies a program as an authenticated program unless the program is included in the program revocation list.

4. The portable memory apparatus of claim 1, 2 or 3, wherein the read-only memory area (312) is set so that copy operations are not allowed.

5. The portable memory apparatus of any preceding claim, wherein the content to be stored in the read-only memory (312) is encrypted with a predetermined content key, and
wherein a content key for decrypting the encrypted content is stored in the special memory area (316).

6. The portable memory apparatus of claim 5, wherein when the content is encrypted by symmetric encryption, the special memory area (316) stores a content key which is identical to a content key that is used in the symmetric encryption.

7. The portable memory apparatus of claim 5, wherein when the content is encrypted by asymmetric encryption, the special memory area (316) stores a private key, which is the content key for decrypting the encrypted content,
wherein the private key corresponds to a public key, and
wherein the public key is a content key used in the asymmetric encryption.

8. The portable memory apparatus of any preceding claim, wherein the special memory area (316) further comprises a content use restriction regulation so that the use of the content is restricted, and
wherein the memory control unit (320) controls the use of the content based on the content use restriction regulation of the special memory area (316).

9. The portable memory apparatus of any preceding claim, wherein the content comprises audio, video, text, and/or software data.

10. A method of manufacturing a portable memory apparatus comprising:
dividing a memory of the portable memory apparatus into a read-only memory area which is set so that only read operations are allowed, a writable memory area which is set so that read and write operations are allowed, and a special memory area which is set so that only authenticated programs are allowed to at least one of read from and write to the special memory area (410);
storing content in the read-only memory area; and
storing information required to operate the portable memory apparatus in the special memory area (430).

11. The method of claim 10 further comprising:
storing a program revocation list which lists a predetermined program that is revoked in the special memory area, and wherein a program is determined as an authenticated program unless the program is included in the program revocation list.

12. The method of claim 10 or 11, wherein the read-only memory area is set so that copy operations are not allowed.

13. The method of claim 10, 11 or 12, further comprising:
encrypting content with a predetermined content key (420); and
storing a content key for decrypting the encrypted content in the special memory area (430),
wherein in the storing the content, the encrypted content is stored in the read-only memory area.

14. The method of claim 13, wherein in the encrypting the content, the content is encrypted by symmetric encryption, and
wherein in the storing the content key, a content key which is identical to a content key used in the symmetric encryption is stored in the special memory area.

15. The method of claim 13, wherein in the encrypting the content, the content is encrypted by asymmetric encryption, and
wherein in the storing the content key, a private key that corresponds to a public key, which is a content key used in the asymmetric encryption, is stored as the content key for decrypting in the special memory area.

16. The method of any one of claims 10-15, wherein the content comprises at least one of audio, video, text, and software data.

17. A computer readable recording medium having recorded thereon instructions, comprising:
dividing a memory of the portable memory apparatus into a read-only memory area which is set so that only read operations are allowed, a writable memory area which is set so that read and write operations are allowed, and a special memory area which is set so that only authenticated programs are allowed to at least one of read from and write to the special memory area;
storing content in the read-only memory area; and
storing information required to operate the portable memory apparatus in the special memory area.
